(19) Europäisches Patentamt

European Patent Office

Office européen des brevets

(11) Veröffentlichungsnummer: **0 280 351 B1**

(12) **EUROPÄISCHE PATENTSCHRIFT**

(45) Veröffentlichungstag der Patentschrift: **13.05.92**

(51) Int. Cl.5: **H05K 9/00**

(21) Anmeldenummer: **88200199.3**

(22) Anmeldetag: **04.02.88**

(54) **Elektromagnetische Dichtungsanordnung.**

(30) Priorität: **07.02.87 DE 3703788**

(43) Veröffentlichungstag der Anmeldung:
**31.08.88 Patentblatt 88/35**

(45) Bekanntmachung des Hinweises auf die
Patenterteilung:
**13.05.92 Patentblatt 92/20**

(84) Benannte Vertragsstaaten:
**DE FR GB IT**

(56) Entgegenhaltungen:
**EP-A- 0 155 393**
**DE-A- 3 101 519**
**GB-A- 2 098 808**

(73) Patentinhaber: **DST Deutsche System-Technik GmbH**
**Hans-Bredow-Strasse 20**
**W-2800 Bremen 44(DE)**

(72) Erfinder: **Kandler, Wilfried**
**Heidacker 13c**
**W-2807 Achim(DE)**
Erfinder: **Prendel, Peter**
**Wiesenstrasse 14**
**W-2803 Weyhe(DE)**
Erfinder: **Prott, Albert**
**Dedesdorferstrasse 18**
**W-2800 Bremen(DE)**
Erfinder: **Sandkuhl, Jürgen**
**Kiefernstrasse 1**
**W-2803 Weyhe-Leeste(DE)**

(74) Vertreter: **Eisenführ, Speiser & Strasse**
**Martinistrasse 24**
**W-2800 Bremen 1(DE)**

**Beschreibung**

Die Erfindung betrifft eine elektromagnetische Dichtungsanordnung aus einem strangförmigen, weichelastischen Dichtungskörper mit im wesentlichen konstantem Querschnitt und einer elektrisch leitenden Oberfläche, der zwischen zwei Gehäuseteilen mit elektrisch leitender Oberfläche in einer Nut des einen Gehäuseteils angeordnet ist, die den größeren Teil des Querschnitts des Dichtungskörpers mit seitlichem Spiel aufnimmt.

Derartige Dichtungsanordnungen werden verwendet, um Gehäuse, die elektronische Schaltungen enthalten, hochfrequenzmäßig dicht zu verschließen siehe beispielsweise die EP-A-0 155 393. Dabei besteht der strangförmige, weichelastische Dichtungskörper häufig aus einem elektrisch leitfähigen Elastomer oder aus einem Strang aus einem Drahtgewirk, der gegebenenfalls als Schlauch auf einem Strang aus elastischem Material aufgezogen ist. Da der Dichtungskörper aus der Nut etwas herausragt, ergibt sich beim Aufsetzen des Deckels eine zuverlässige elektrische Verbindung an sehr vielen, eng benachbarten Punkten, so daß eine zuverlässige hochfrequenzmäßige Dichtung erreicht werden kann. Da der Dichtungskörper beim Zusammensetzen der Gehäuseteile verformt wird, muß die Nut etwas breiter sein als der Dichtungskörper, der daher mit einem gewissen seitlichen Spiel in der Nut liegt, damit der Dichtungskörper sich beim Verformen seitlich ausdehnen kann. Dadurch besteht jedoch die Gefahr, daß der Dichtungskörper bei getrennten Gehäuseteilen leicht aus der Nut herausfällt, insbesondere wenn die Gehäusefläche mit der Nut senkrecht oder gar über Kopf steht.

In der Zeitschrift "Microwaves" vom Oktober 1982 ist auf Seite 97 eine Nut mit schwalbenschwanzförmiger Verbreiterung zum Nutgrund hin dargestellt, in der ein eingelegter Dichtungskörper relativ fest gehalten wird. Derartige Nutformen sind jedoch nur schwer und aufwendig herzustellen.

Aufgabe der Erfindung ist es daher, eine Dichtungsanordnung der eingangs genannten Art anzugeben, in der der Dichtungskörper trotz seitlichem Spiel in der Nut so festgehalten wird, daß er nicht ohne weiteres aus der Nut herausfallen kann, wobei die Nut einfach herstellbar ist.

Diese Aufgabe wird erfindungsgemäß dadurch gelöst, daß die Nut an mehreren, im wesentlichen gleichmäßig verteilten Stellen ihre Richtung wesentlich mit einem Radius ändert, der in der Größenordnung der Breite der Nutliegt.

Es wird also die stets vorhandene Eigensteifigkeit des Dichtungskörpers ausgenutzt, so daß er durch die Richtungsänderung der Nut zumindest stellenweise an den Rand der Nut gedrückt wird und dadurch festklemmt, während beim Aufsetzen des anderen Gehäuseteils dennoch eine seitliche Ausdehnungsmöglichkeit des Dichtungskörpers erhalten bleibt. Die Anzahl bzw. der Abstand der Stellen der Richtungsänderungen richtet sich nach der Steifigkeit des Dichtungskörpers, dem Ausmaß der Richtungsänderung sowie den Anforderungen, wie fest der Dichtungskörper in der Nut bei offenem Gehäuse gehalten werden soll.

Die Richtungsänderungen der Nut können derart vorgesehen werden, daß diese beispielsweise einen zickzackförmigen Verlauf hat. Dadurch erfordert die Nut jedoch eine größere Fläche in dem Gehäuseteil. Eine günstigere Lösung ist nach einer Ausgestaltung der Erfindung dadurch gekennzeichnet, daß die Nut an jeder Stelle die Richtung zweimal kurz nacheinander jeweils entgegengesetzt ändert, so daß die Nut an jeder Stelle lediglich mit einem seitlichen Versatz im wesentlichen kontinuierlich weiter verläuft. Insbesondere ist es vorteilhaft, daß der seitliche Versatz kleiner als die Breite der Nut ist. Auf diese Weise wird durch die erfindungsgemäße Form der Nut eine nur wenig verbreiterte Fläche in dem betreffenden Gehäuseteil benötigt, ohne daß die Fähigkeit der Nut, den Dichtungskörper festzuhalten, wesentlich beeinträchtigt ist. Insbesondere im letzten Fall ist es dabei zweckmäßig, daß die Richtungsänderung etwa 90° beträgt. Dadurch wird auch ein Dichtungskörper mit geringer Eigensteifigkeit gut gehalten.

Da im Bereich der Richtungsänderung, insbesondere wenn diese sehr stark ist, der Dichtungskörper relativ eng an der einen Wandung der Nut anliegt, kann es bei einem Dichtungskörper mit oder aus einem Drahtgewirk geschehen, daß beim Zusammensetzen der Gehäuseteile einzelne Teile des Drahtgewirks zwischen die aufeinanderliegenden Gehäuseflächen gerät und somit ein gleichmäßiges mechanisches und elektrisches Abdichten der Gehäuseteile verhindert. Dafür ist es nach einer weiteren Ausgestaltung der Erfindung zweckmäßig, daß an jeder Stelle die Nut im Bereich der Oberfläche eine Verbreiterung aufweist. Diese Verbreiterung ist zweckmäßig so bemessen, daß eventuell überstehende Teile des Dichtungskörpers beim Zusetzen der Gehäuseteile mit Sicherheit im Bereich dieser Verbreiterung liegen und somit das mechanisch dichte Aufeinanderliegen der Gehäuseteile nicht beeinträchtigen können.

Ausführungsbeispiele der Erfindung werden nachstehend anhand der Zeichnung näher erläutert. Es zeigen:

Fig. 1    zwei Gehäuseteile mit einer Nut zur Aufnahme des Dichtungskörpers in einem Gehäuseteil,

Fig. 2 und 3    zwei mögliche Ausführungen von Richtungsänderungen im Verlauf der Nut,

Fig. 4 einen Querschnitt durch einen Teil des Gehäuses und die Nut mit eingelegtem Dichtungskörper.

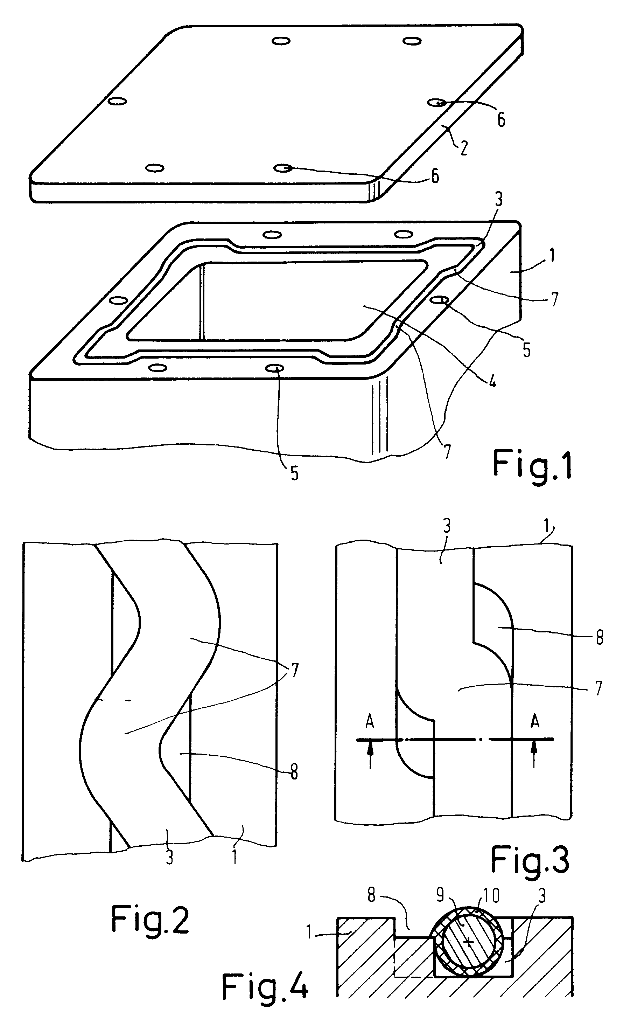

In Fig. 1 ist von einem Gehäuseteil 1 der Bereich dargestellt, auf den ein Deckel 2 befestigt werden soll. Dies geschieht mittels Schrauben durch Löcher 6 im Deckel, die beispielsweise in Gewindebohrungen 5 eingeschraubt werden. In dem offenen Bereich 4 des Gehäuseteils 1 ist eine nicht dargestellte elektronische Schaltungsanordnung eingebaut.

In die Oberfläche des Gehäuseteils 1 ist eine Nut 3 eingebracht, beispielsweise durch Fräsen, die um den gesamten Rand des Gehäuseteils 1 in Form eines geschlossenen Ringes verläuft. Diese Nut weist an Stellen 7 Richtungsänderungen auf, und zwar in Form eines seitlichen Versatzes. In diese Nut 3 wird ein Dichtungskörper eingelegt, der eine leitende Oberfläche hat und über die Oberfläche des Gehäuseteils 1 hinausragt, so daß beim Aufschrauben des Deckels 2 zwischen dem Gehäuseteil 1 und dem Deckel 2, die beide aus elektrisch leitendem Metall bestehen, über den Dichtungskörper an sehr vielen Punkten mit geringem Abstand elektrisch leitende Verbindungen hergestellt werden. Dadurch ist eine hochfrequenzmäßige Abdichtung gewährleistet.

In Fig. 2 ist ein Abschnitt der Oberfläche des Gehäuseteils 1 dargestellt, in dem eine zickzackförmige Nut vorhanden ist. An den Stellen 7 ändert sich jeweils die Richtung der Nut 3, so daß ein darin eingelegter Dichtungskörper an der Innenseite des jeweiligen Bogens der Nut infolge seiner Eigensteifigkeit anliegt. Derartige Nuten werden üblicherweise auf numerisch gesteuerten Fräsmaschinen hergestellt, so daß es ohne wesentliche Kostensteigerung möglich ist, nahezu beliebige Verläufe einer derartigen Nut herzustellen. Damit ist die Herstellung einer Nut mit mehreren Richtungsänderungen ohne wesentlichen zusätzlichen Kostenaufwand möglich.

Die Fig. 2 zeigt jedoch, daß ein derartiger zickzackförmiger Nutenverlauf eine im Vergleich zur Breite der Nute breiten Rand des Gehäuses 1 erfordert, wenn nicht eine sehr enge Aufeinanderfolge der Bögen der Nut vorgesehen wird. Eine andere Möglichkeit ist in Fig. 3 dargestellt, wo die Nut 3 in der Oberfläche des Gehäuseteils 1 an der Stelle 7 mit einem seitlichen Versatz verläuft. Ein derartiger Versatz kann leicht dadurch hergestellt werden, daß beim Fräsen der Nut 3 an der Stelle 7 der Vorschub kurzzeitig um 90° in der Richtung verändert wird und danach wieder in der ursprünglichen Richtung weitergefräst wird.

Beim Einlegen eines Dichtungskörpers legt sich dieser an den inneren Seitenflächen der Bögen der Nut 3 an, so daß insbesondere bei einem Dichtungskörper, der zumindest an der Oberfläche aus einem auftragenden Drahtgewirk besteht, einzelne Teile des Gewirks über die Kante der Nut hinaus über die Oberfläche des Gehäuseteils 1 gedrückt werden können, und beim Aufsetzen des Deckels 2 diese Teile des Gewirks dann zwischen den Flächen der Gehäuseteile 1 und 2 liegen, die dann nicht vollständig aufeinanderliegen. Aus diesem Grunde wird an den Stellen 7 mindestens im Bereich der Innenbögen der Nut 3 diese in einem Bereich 8 nahe der Oberfläche verbreitert. Dies wird anhand eines in Fig. 4 gezeigten Schnitts AA durch den Rand des Gehäuses 1 erläutert. In die Nut 3 ist ein Dichtungskörper eingelegt, der aus einem runden Kern 9 aus elastischem Material besteht, der mit einem Gewirk 10 aus Metalldrähten überzogen ist. Aufgrund des Verlaufs der Nut 3 in Fig. 3 wird dieser Dichtungskörper an die linke Wand dieser Nut gedrückt. Die Nut 3 weist im Bereich der Oberfläche nun eine Verbreiterung 8 auf, so daß ein über den Grund dieser Verbreiterung 8 hinausragender Teil des Gewirks 10 beim Aufsetzen des Deckels 2 nicht zwischen die beiden aufeinanderliegenden Flächen der Gehäuseteile 1 und 2 geraten kann.

## Patentansprüche

1. Elektromagnetische Dichtungsanordnung aus einem strangförmigen, weichelastischen Dichtungskörper mit im wesentlichen konstantem Querschnitt und einer elektrisch leitenden Oberfläche, der zwischen zwei Gehäuseteilen mit elektrisch leitender Oberfläche in einer Nut des einen Gehäuseteils angeordnet ist, die den größeren Teil des Querschnitts des Dichtungskörpers mit seitlichem Spiel aufnimmt, dadurch gekennzeichnet, daß die Nut (3) an mehreren im wesentlichen gleichmäßig verteilten Stellen (7) ihre Richtung mindestens zweimal nacheinander jeweils entgegengesetzt mit einem Radius ändert, der in der Größenordnung der Breite der Nut (3) liegt.

2. Dichtungsanordnung nach Anspruch 1, dadurch gekennzeichnet, daß die Nut (3) an jeder Stelle (7) die Richtung zweimal kurz nacheinander jeweils entgegengesetzt ändert, so daß die Nut (3) an jeder Stelle (7) lediglich mit einem seitlichen Versatz im wesentlichen kontinuierlich weiter verläuft.

3. Dichtungsanordnung nach Anspruch 2, dadurch gekennzeichnet, daß der seitliche Versatz kleiner als die Breite der Nut (3) ist.

**4.** Dichtungsanordnung nach einem der Ansprüche 1 bis 3,
dadurch gekennzeichnet, daß die Richtungsänderung etwa 90° beträgt.

**5.** Dichtungsanordnung nach einem der Ansprüche 1 bis 4,
dadurch gekennzeichnet, daß an jeder Stelle (7) die Nut (3) im Bereich der Oberfläche eine Verbreiterung (8) aufweist.

## Claims

**1.** An electromagetic sealing arrangement made of a softly elastic sealing body in the form of a strand of essentially constant cross-section with an electrically conductive surface, arranged between the two parts of a housing having an electrically conductive surface, in a groove in one of the parts of the housing, which receives the greater part of the cross-section of the sealing body with lateral play, characterized in that the groove (3) at a number of essentially uniformly distributed points (7) changes its direction at least twice in succession to and fro at a radius which is of the order of magnitude of the width of the groove (3).

**2.** A sealing arrangement as in Claim 1, characterized in that at each point (7) the groove (3) changes direction twice in rapid succession to and fro so that at each point (7) the groove (3) essentially runs on continuously with merely a jog to one side.

**3.** A sealing arrangement as in Claim 2, characterized in that the jog to the side is less than the width of the groove (3).

**4.** A sealing arrangement as in one of the Claims 1 to 3, characterized in that the change in direction amounts to about 90°.

**5.** A sealing arrangement as in one of the Claims 1 to 4, characterized in that at each point (7) the groove exhibits a widening (8) in the region of the surface.

## Revendications

**1.** Ensemble formant joint d'étanchéité électromagnétique composé d'un corps de joint d'étanchéité souple qui présente une section droite sensiblement constante et une surface extérieure électriquement conductrice, et qui est disposé entre deux parties de carter présentant une surface extérieure électriquement conductrice, dans une rainure de l'une des parties de carter, qui reçoit la plus grande partie de la section droite du corps de joint d'étanchéité avec un jeu latéral, caractérisé en ce qu'en plusieurs endroits (7) sensiblement répartis de manière régulière, la rainure (3) effectue au moins deux changements de direction successifs et respectivement opposés, présentant un rayon de l'ordre de grandeur de la largeur de la rainure (3).

**2.** Ensemble formant joint d'étanchéité selon la revendication 1, caractérisé en ce qu'à chaque endroit (7) la rainure (3) effectue deux courts changements de direction successifs et respectivement opposés, de sorte qu'à chaque endroit (7), la rainure (3) s'étend sensiblement de manière continue en présentant un simple déport latéral.

**3.** Ensemble formant joint d'étanchéité selon la revendication 2, caractérisé en ce que le déport latéral est inférieur à la largeur de la rainure (3).

**4.** Ensemble formant joint d'étanchéité selon l'une des revendications 1 à 3, caractérisé en ce que le changement de direction est d'environ 90°.

**5.** Ensemble formant joint d'étanchéité selon l'une des revendications 1 à 4, caractérisé en ce qu'à chacun des endroits (7), la rainure (3) présente un élargissement (8) dans la zone de la surface extérieure.

Fig.1

Fig.2

Fig.3

Fig.4